Europäisches Patentamt

European Patent Office

Office européen des brevets

(11) Publication number: **0 412 323 A2**

# EUROPEAN PATENT APPLICATION

(21) Application number: **90113613.5**

(22) Date of filing: **16.07.90**

(51) Int. Cl.⁵: **H01L 23/14**

(30) Priority: **07.08.89 JP 202890/89**

(43) Date of publication of application:
**13.02.91 Bulletin 91/07**

(84) Designated Contracting States:
**AT BE CH DE DK ES FR GB GR IT LI LU NL SE**

(71) Applicant: **JAPAN GORE-TEX, INC.**
**42-5, 1-chome Akazutsumi**
**Setagaya-ku Tokyo 156(JP)**

(72) Inventor: **Fukutake, Sunao**
**356-1 Nagaoka**
**Okayama-shi, Okayama-ken(JP)**
Inventor: **Hatakeyama, Minoru**
**1-22, 7-chome, Sakuragoakanishi, Sanyo-cho**
**Akaiwa-gun, Okayama-ken(JP)**

(74) Representative: **Klunker . Schmitt-Nilson .**
**Hirsch**
**Winzererstrasse 106**
**D-8000 München 40(DE)**

(54) A film carrier for use in integrated circuit mounting.

(57) An improved electrical integrated circuit mounting is provided, the improvement being a film carrier comprising an electrical conductor laminated to an insulating base film, in which the base film contains at least one porous resin sheet. The preferred porous resin is porous, expanded polytetrafluoroethylene.

EP 0 412 323 A2

## BACKGROUND OF THE INVENTION

The invention relates to integrated circuits, in particular to a film carrier for an integrated circuit (IC) mounting. Specifically, the invention concerns an improved base film material and an improved adhesive agent used in the carrier.

Conventional film carriers used in tape-automated bonding (TAB) typically have a three-layer structure as depicted in Fig. 10 in which a conductor 1 is affixed to a base film 3 by an adhesive layer 2. The purpose of this structure is to insure a good yield in terms of inner lead bonding and outer lead bonding by using the base film 3 around the periphery of the IC chip 4 to prevent misalignment of the inner leads 5 and outer leads 6. Such a structure is particularly necessary in the case of film carriers used to multi-pin IC's in which fine-pitch patterns are required. Such a structure is also required in cases where chip parts such as resistors, capacitors or diodes and the like are surface-mounted on the film carrier 7. Another structure used in film carriers used for TAB is a structure in which the aforementioned conductor is directly attached to the base film without using an adhesive agent. Such a structure is referred to as a two-layer tape in contrast to a three-layer tape which uses an adhesive agent.

"Double sided" film carriers, in which conductors are installed on both sides of a base film, are also known, as are film carriers with a multi-layer structure consisting of base films, conductors and through-holes. Grounding tapes, area tapes and pin grid array (PGA) type systems are also being investigated as possible applications.

In such film carriers, copper foil is generally used for the conductor(s), polyimide films, glass cloth - epoxy resins or glass cloth - BT resins are generally used for the base film(s), and an epoxy type adhesive agent is generally used for the adhesive.

In conventional film carriers of the types discussed above, the dielectric constant of the base film is relatively high, i.e., 3.2 to 3.6 in the case of polyimides; 4.7 to 5.0 in the case of glass cloth - epoxy resins; and 3.7 to 3.9 in the case of glass cloth - BT resins. As a result, there are limits to the rate of signal transmission speed between the mounted IC chips and the substrate, so that requirements for high-speed signal transmission often cannot be fully satisfied.

Accordingly, an object of the present invention is to provide a film carrier for use in IC mounting which is superior in terms of signal speed transmission rate.

## SUMMARY OF THE INVENTION

In an integrated circuit (IC) mounting, an improved film carrier is provided. The improvement comprises a film carrier including an electrical conductor laminated to an insulating composite film, wherein the base film contains at least one porous resin sheet therein. The base film preferably is a laminated composite of a porous resin sheet and a solid, non-porous resin sheet. The film carrier may include two or more electrical conductors and insulating base films laminated together to form a double-sided film carrier. The porous resin sheet preferably is porous, expanded polytetrafluoroethylene and the non-porous resin sheet preferably is a polyimide resin sheet.

## BRIEF DESCRIPTION OF THE DRAWINGS

Fig. 1 is a cross-sectional diagram of one embodiment of the film carrier of the present invention with mounted IC's.

Figs. 2 and 4-9 are diagrams which illustrate alternative embodiments of the film carrier according to the invention.

Fig. 3 is a schematic diagram of the process of manufacture of the film carrier of the invention illustrated in Fig. 2.

Fig. 10 is a diagram which illustrates a conventional film carrier for use in IC mounting.

## DETAILED DESCRIPTION OF THE INVENTION AND PREFERRED EMBODIMENTS WITH REFERENCE TO THE DRAWINGS

An improved electrical integrated circuit mounting is provided, the improvement being a film carrier comprising an electrical conductor laminated to an insulating base film, in which the base film contains at least one porous resin sheet. The preferred porous resin is porous, expanded polytetrafluoroethylene.

Specifically, the present invention provides a film carrier for use in IC mounting wherein a film carrier for use in IC mounting is equipped with a conductor and an insulating base film, the base film containing a porous resin sheet. A porous resin sheet is used for at least a portion of the base film.

As long as a porous resin sheet is used for at least a portion of the base film, there are no particular restrictions on the internal composition of the film carrier or on the form in which the film carrier is used for IC mounting. Specifically, a single base film may be used, and this may be a porous resin sheet alone, or it may have a composite laminated structure of a porous resin sheet and a solid resin sheet. Alternatively, in the case of a multi-layer construction, all or part of the multi-layer base film may be porous resin sheets. Regarding the IC mounting configuration, the film carrier may be used as a simple TAB tape, or as a complex multi-layer film carrier.

Adhesive agents or bonding agents may also be used.

In an especially preferred configuration of the present invention, a porous, expanded polytetrafluoroethyelene (EPTFE) sheet is used as the base film(s). The dielectric constant of polytetrafluoroethyelene (PTFE) is 2.1, and may be as low as 1.2 in the case of EPTFE. Accordingly, the effect of this material in improving the signal transmission rate is considerable. For the same reason, it is desirable to use fluororesins ($\epsilon_r$ = 2 to 3) as adhesive agents or bonding agents. Similarly, the use of solid PTFE sheets is also desirable.

EPTFE is available commercially from W. L. Gore & Associates, Inc., Elkton, MD. Its manufacture is disclosed in U.S. Patent 3,953,566.

By making the base film(s) porous, the dielectric constant of this film(s) can be lowered, since the dielectric constant of air is low (1.0). Furthermore, the dielectric constant of the base film(s) can be lowered even further by using porous EPTFE. Because porous resin sheets also have considerable pliability, the use of such sheets also contributes to the lowering of thermal stresses created by differences in the coefficient of linear expansion between the conductor(s) and the base film(s).

Examples of application of the present invention are described below with reference to the accompanying drawings.

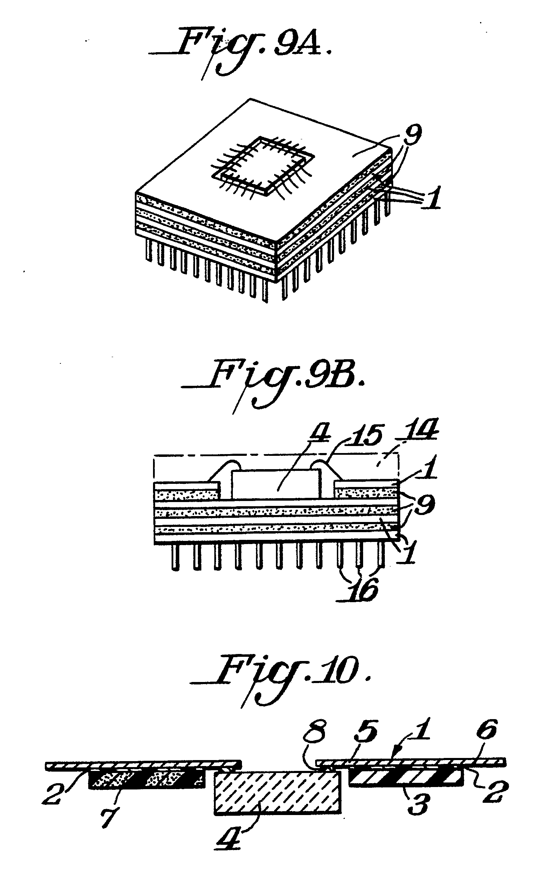

In the example illustrated in Fig. 1, a porous EPTFE sheet 9 is installed on the undersurface of a conductor 1 by means of a fluororesin adhesive layer 2. As a result, misalignment of the inner leads 5 is substantially prevented. As a result of the superior dielectric characteristics ($\epsilon_r$ = 1.2) of the porous EPTFE sheet 9, the signal transmission delay in the conductor 1 on the film carrier 7 can be reduced. Moreover, since the porous EPTFE sheet 9 has considerable pliability, this sheet 9 also contributes to the lowering of thermal stresses created by any difference in the coefficient of linear expansion between the conductor 1 and the base film 7.

Fig. 2 shows an example in which the base film of the film carrier is composed of a porous resin sheet and a solid resin sheet. Specifically, a fluororesin adhesive layer 2, a porous EPTFE sheet 9, another fluororesin adhesive layer 2 and a polyimide base film 3 are installed, in that order, on the undersurface of a conductor 1, thus forming a film carrier 7′. The porous EPTFE sheet 9 acts to improve the electrical characteristics, while the polyimide base film 3 acts to improve the mechanical strength of the film carrier as a whole, and to reduce the shrinkage of the porous EPTFE sheet 9 caused by heating. The conductor 1 is bonded to the porous EPTFE sheet 9, and the porous EPTFE sheet 9 is bonded to the polyimide base film 3, using a fluororesin adhesive agent which is superior in terms of electrical characteristics. The fluororesin adhesive in this example and in all the examples may be a fluorinated ethylene propylene adhesive.

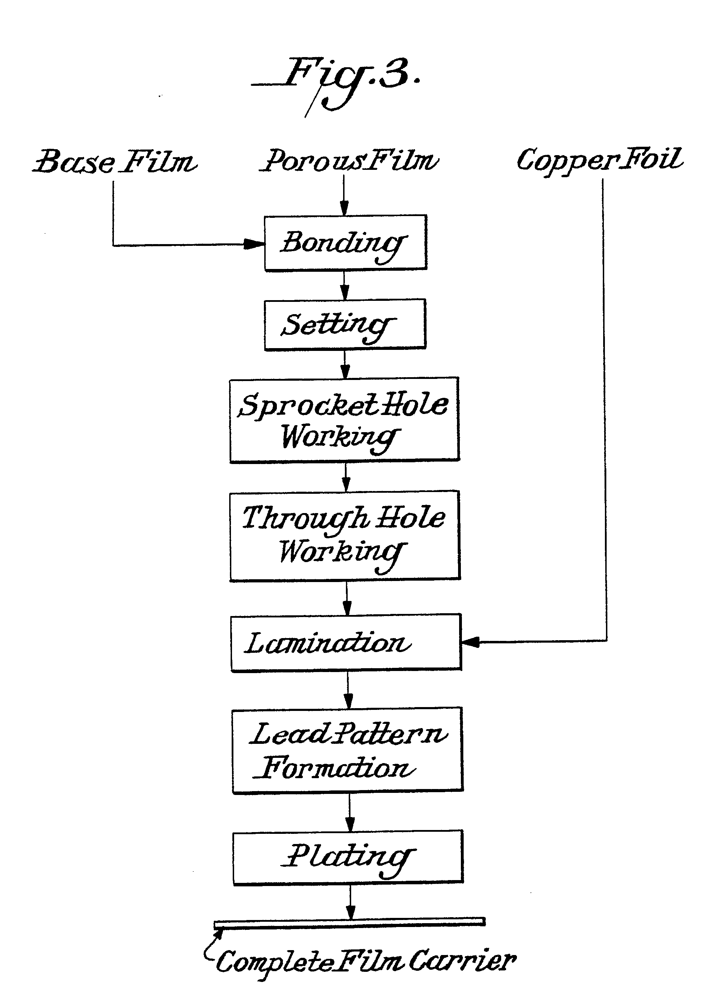

Such a base film can be manufactured by the process schematically illustrated in Fig. 3. Following the bonding of the porous film and the solid film, slitting, sprocket hole working and throughhole working are performed, after which the copper foil forming the conductor is laminated with the bonded sheets by means of hot rolls. The copper foil is then patterned, after which plating is performed in order to form the bumps 8, thereby producing the completed film carrier.

When a film carrier with the structure illustrated in Fig. 2 was manufactured by the process illustrated in Fig. 3, the dielectric constant of the film carrier as a whole was 1.8 to 1.9.

Fig. 4 shows an example of a "double-sided" tape structure which has through-holes. Here, a porous EPTFE sheet 9 is installed on the undersurface of a first conductor layer 11. This porous EPTFE sheet 9 is bonded to a polyimide base film 3, and a second conductor layer 12 connects with the ground terminal of the IC chip 4 via throughhole 13. As a result of this structure, effects which are characteristic of "double-sided" type film carriers that use a microstrip line structure, i.e., impedance matching, reduction of crosstalk and reduction of ground impedance, can be obtained more advantageously.

Similarly, the abovementioned effects can also be obtained in a multi-layer type film carrier which has three or more conductor layers, with separate signal lines, power supply lines and ground lines.

The abovementioned conductor(s) need not be formed by the bonding of copper foil. The conductor(s) may also be formed by methods such as sputtering or electroless plating, or the like on the base film, particularly on the porous EPTFE sheet. In such cases, the electrical characteristics may be improved because no adhesive agent is used.

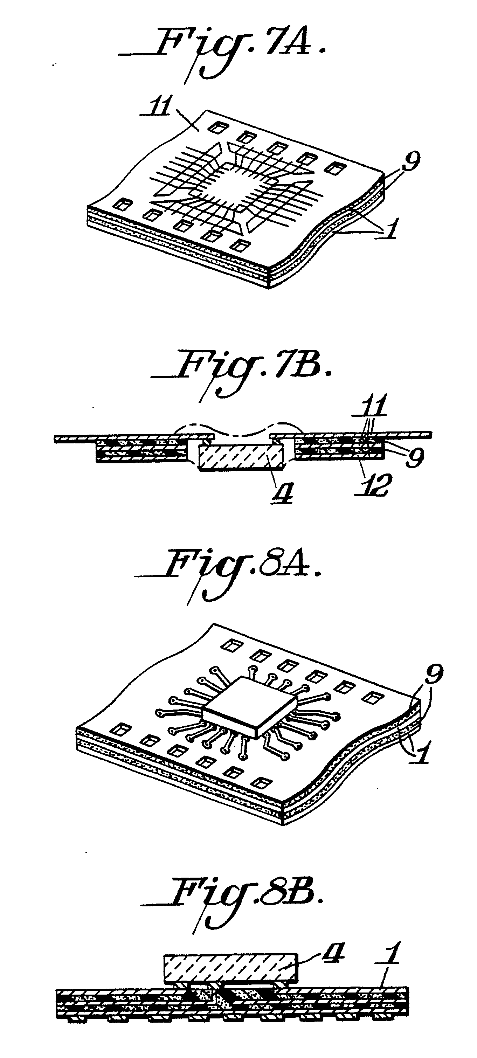

Figs. 5 and 6 show other examples of film carriers in which the porous EPTFE sheet 9 shown in Figs. 1, 2 and 4 is installed on the undersurface of a conductor 1. These figures illustrate: (a) a structure in which the electrode pads of the IC chip 4 and the inner leads 5 of the film carrier are bonded, after which the surface of the IC chip only, including the electrode pads, is coated with a bonding and sealing material 14 such as a fluororesin or epoxy resin or the like, which has a dielectric constant of 4 or less (Fig. 5); and (b) a structure in which the entire mounting portion of the IC chip 4 is sealed by bonding or transfer molding using one of the aforementioned resins (Fig. 6). By sealing the IC chip using such a resin with its low dielectric constant, it is possible to improve the moisture resistance of the device without sacrificing the electrical characteristics.

Figs. 7 through 9 illustrate practical examples of film carriers with multi-layer structures. Fig. 7 shows a structure which is referred to as a "ground tape". This structure is basically similar to the structure illustrated in Fig. 4, except that the film carrier is a multi-layer film carrier. In Fig. 7, the reference numerals are the same as in Fig. 4, the conductors are indicated by 11.

Fig. 8 shows a structure which is referred to as an "area tape". Here, the IC chip is mounted not in a device hole, but rather in a flip-chip mounting on the surface of the film carrier.

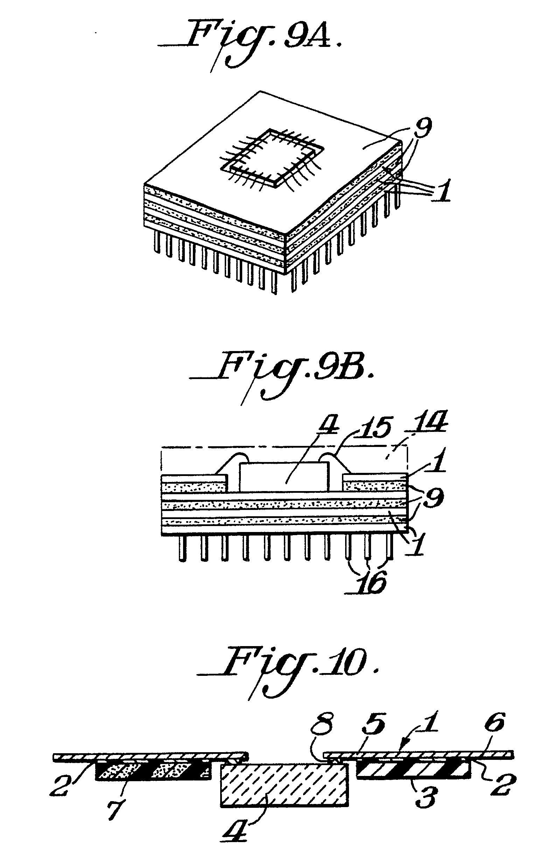

Fig. 9 shows a structure which is referred to as a "pin grid array" (PGA). This structure belongs to the category of plastic PGA's. The mounting of the IC chip is performed by the wire bonding method, TAB method or flip-chip method. This is another example of the film carrier of the present invention.

In the structure shown in Figs. 7 through 9, a porous EPTFE sheet is used for at least a portion of each base film. In these structures, it is desirable to lower the dielectric constant by using as much porous EPTFE as possible, within the limits dictated by strength considerations. Although only a single IC chip is shown in each figure, it would also be possible to mount a plurality of IC's.

In the present invention, porous resin sheets, especially porous EPTFE sheets, are used in the base films on the undersurfaces of the conductors, and fluororesins are used as adhesive agents. As a result, the signal transmission rate between the mounted IC chip(s) and the carrier can be improved, and noise can be reduced.

While the invention has been disclosed herein in connection with certain embodiments and detailed descriptions, it will be clear to one skilled in the art that modifications or variations of such details can be made without deviating from the gist of this invention, and such modifications or variations are considered to be within the scope of the claims hereinbelow.

## Claims

1. In an integrated circuit (IC) mounting, an improved film carrier, the improvement comprising a film carrier comprising an electrical conductor laminated to an insulating base film, wherein said base film contains at least one porous resin sheet.

2. The IC mounting of claim 1 wherein said base film is a laminated composite of a porous resin sheet and a solid, non-porous resin sheet.

3. The IC mounting of claim 1 wherein said film carrier comprises two or more electrical conductors and insulating base films laminated together to form a double-sided film carrier.

4. The IC mounting of claim 1 wherein said porous resin sheet is a porous, expanded polytetrafluoroethylene.

5. The IC mounting of claim 2 wherein said non-porous resin sheet is a polyimide resin sheet.

*Fig. 9A.*

*Fig. 9B.*

*Fig. 10.*

5

# _Fig.3._

Base Film    PorousFilm    CopperFoil

```
                    ┌──────────────┐
                    │   Bonding    │
                    └──────────────┘
                            │
                    ┌──────────────┐
                    │   Setting    │
                    └──────────────┘
                            │
                    ┌──────────────┐
                    │ Sprocket Hole│
                    │   Working    │
                    └──────────────┘
                            │
                    ┌──────────────┐
                    │ Through Hole │
                    │   Working    │
                    └──────────────┘
                            │
                    ┌──────────────┐
                    │  Lamination  │◄──────
                    └──────────────┘
                            │
                    ┌──────────────┐
                    │ Lead Pattern │
                    │  Formation   │
                    └──────────────┘
                            │
                    ┌──────────────┐
                    │   Plating    │
                    └──────────────┘
                            │
                    ─────────────────
```

Complete Film Carrier

*Fig. 7A.*

*Fig. 7B.*

*Fig. 8A.*

*Fig. 8B.*

Fig. 9A.

Fig. 9B.

Fig. 10.